# EUROPÄISCHE PATENTSCHRIFT

(11) **EP 1 444 875 B1**
(45) Veröffentlichungstag und Bekanntmachung des Hinweises auf die Patenterteilung: **18.01.2006**
(21) Anmeldenummer: 02779534.3
(22) Anmeldetag: 07.11.2002
(51) Int. Cl.: H05K 5/02

(54) **GEHÄUSEKOMPONENTE FÜR EINE ZU BELÜFTENDE EINRICHTUNG**
HOUSING COMPONENT FOR A DEVICE TO BE VENTILATED
COMPOSANT DE BOITIER POUR DISPOSITIF A VENTILER

(30) Priorität: 14.11.2001 DE 10155810
(43) Veröffentlichungstag der Anmeldung: 11.08.2004
(73) Patentinhaber: MINEBEA Co., Ltd., Kitasaku-gun, Nagano-ken (JP)
(72) Erfinder: BREIER, Anton, 86316 Friedberg (DE)
(74) Vertreter: Liesegang, Eva
(86) Internationale Anmeldenummer: PCT/EP2002/012439
(87) Internationale Veröffentlichungsnummer: WO 2003/043395

(56) Entgegenhaltungen:
- EP-A- 0 843 512
- US-A- 5 460 571
- US-A- 5 608 609

## Beschreibung

Die Erfindung betrifft eine Gehäusekomponente für eine zu belüftende Einrichtung mit einem flächigen Wandabschnitt und einem perforierten Durchlaß in dem Wandabschnitt, der mehrere Öffnungen und zwischen den Öffnungen liegende Stege aufweist.

Zahlreiche elektrische und elektronische Einrichtungen, wie Stromversorgungen und Netzteile jeder Art, Computer und andere elektronische Geräte, müssen in vielen Anwendungen gekühlt werden, wobei zur Unterstützung der Kühlung häufig Lüfter in den Einrichtungen eingesetzt werden, bei manchen Geräten die Kühlung jedoch auch aufgrund freier Konvektion erfolgen kann.

Um eine ausreichende Kühlung solcher Einrichtungen sicherzustellen, weisen deren Gehäuse in der Regel wenigstens einen perforierten Durchlaß in einer Gehäusewand auf, der mehrere Öffnungen und zwischen den Öffnungen liegende Stege aufweist, um eine Luftströmung durch das Gehäuse zu ermöglichen. Während eine optimale Belüftung des Gehäuses durch einen vollständig offenen Durchlaß erreicht werden könnte, werden in der Regel gitterartige Belüftungsöffnungen bevorzugt, weil diese einen gewissen mechanischen Schutz der in dem Gehäuse liegenden Einrichtungen gewährleisten und, bei Verwendung von Metallgehäusen, eine elektromagnetische Abschirmung der elektrischen und elektronischen Bauteile sicherstellen. Die Öffnungen in den Belüftungsdurchlässen sind häufig in Form von Schlitzen ausgebildet, wobei die Öffnungen um so kleiner sein sollten, je höher die Frequenzen der elektromagnetischen Wellen sind, welche durch das Gehäuse abgeschirmt werden sollen. Eine solche Vorrichtung ist in der US-A-5 460 571 offenbart.

Bei den heute üblichen Perforationen oder Lochungen zur Ausbildung von Lüftungsdurchlässen in Gehäusewände ist es äußerst schwierig, ein Verhältnis der freien Fläche zur Gesamtfläche des perforierten Durchlasses von mehr als 80 % zu erreichen, ohne daß die mechanische Stabilität und die elektromagnetische Abschirmwirkung gefährdet würden. Der Erfindung liegt daher die Aufgabe zugrunde, eine Gestaltung für Lüftungsdurchlässe in Gehäusewänden von elektrischen oder elektronischen Einrichtungen, die zu ihrer Kühlung belüftet werden sollen, anzugeben, die eine maximale Luftströmung ermöglicht und gleichwohl eine ausreichende elektromagnetische Abschirmung der Einrichtung im Inneren des Gehäuses gewährleistet.

Diese Aufgabe wird bei einer Gehäusekomponente der eingangs genannten Art durch die Merkmale des Anspruchs 1 gelöst. Dabei sind die zwischen den Öffnungen des perforierten Durchlasses liegenden Stege gegenüber der Fläche des Wandabschnittes versetzt. Vorzugsweise sind die Stege nach innen oder außen gebogen und dadurch verlängert.

Eine Luftströmung durch den perforierten Durchlaß ist immer mit einem Druckabfall verbunden. Die Erfindung erreicht eine Minimierung dieses Druckabfalls und somit eine Maximierung der Strömungsraten für die Kühlung von elektrischen und elektronischen Einrichtungen durch eine Vergrößerung der freien Fläche im Verhältnis zur Gesamtfläche des perforierten Durchlasses, indem für den perforierten Durchlaß die dritte Dimension genutzt wird. Indem die zwischen den Öffnungen liegenden Stege gegenüber der Fläche des Wandabschnittes, in dem der Durchlaß ausgebildet ist, versetzt sind, insbesondere von dieser Fläche vorstehen und in Form eines Bogensegments, Ellipsensegments, einer Welle oder dergleichen gebogen sind, nimmt ihre effektive Länge zu, wodurch sich auch die offene Fläche zwischen den Stegen vergrößert. Die Gesamtfläche der Durchtrittsöffnungen wird bestimmt durch die Abmessungen der jeweiligen Seitenkanten der Stege, welche die Durchtrittsöffnungen eingrenzen, und somit im wesentlichen durch die Längenabmessungen der Stege. Die Grundfläche des gesamten perforierten Durchlasses bleibt immer unverändert. Mit der erfindungsgemäßen Gestaltung des Lüftungsdurchlasses kann somit der Anteil der freien Fläche zur Grundfläche erhöht werden, was zu einem verringerten Strömungswiderstand führt. Dadurch kann eine im wesentlichen identische Luftströmung und somit gleiche Kühlwirkung mit einer reduzierten Lüftergeschwindigkeit erreicht werden, wodurch sich sowohl eine Energieeinsparung als auch eine geringere Geräuschentwicklung ergeben. Nach Bedarf kann auch mit derselben Lüfterdrehzahl eine erhöhte Strömungsgeschwindigkeit und somit eine bessere Kühlwirkung verwirklicht werden.

Wie oben erläutert ist die Netto-Freifläche für die Luftströmung bestimmt durch die von den Stegen eingegrenzten Schlitze, gemessen senkrecht zur effektiven Oberfläche der Stege, wodurch sich durch das Biegen eine Verlängerung der Stege und somit eine Vergrößerung der Oberfläche und damit der Freifläche ergibt. Da jedoch die Grundfläche des perforierten Durchlasses insgesamt unverändert ist, erhöht sich der Anteil der effektiven Freifläche ohne nennenswerte Reduzierung der Breite der Stege.

Wie oben erläutert, dient das Gehäuse von elektrischen und elektronischen Einrichtungen auch zur Abschirmung elektromagnetischer Felder. Zu diesem Zweck ist das Gehäuse in der Regel aus Metall. Mit der erfindungsgemäßen Gestaltung des Durchlasses kann der Anteil der effektiven freien Fläche deutlich erhöht werden, ohne die elektromagnetische Abschirmwirkung zu beeinträchtigen. Die effektive Abschirmung wird bestimmt durch den größten "offenen Durchmesser" in der Gehäusewand. Da die erfindungsgemäße Gestaltung des perforierten Durchlasses diesen größten offenen Durchmesser nicht verändert, hat die Erfindung keinen negativen Einfluß auf die elektromagnetische Abschirmwirkung.

Die erfindungsgemäße Gehäusekomponente wird vorzugsweise in Metallgehäusen für elektrische und elektronische Einrichtungen und insbesondere Netzteile, Computer und dergleichen eingesetzt. Sie ist anwendbar in allen Fällen, in denen elektrische oder elektronische Komponente mittels einer Luftströmung gekühlt werden sollen, wobei die Luftströmung durch einen Lüfter oder durch freie Konvektion erzeugt werden kann. Durch die erfindungsgemäße Gestaltung des perforierten Durchlasses wird der Strömungswiderstand deutlich verringert.

Die Erfindung ist im folgenden anhand bevorzugter Ausführungsformen mit Bezug auf die Zeichnungen näher erläutert. In den Figuren zeigen:
- Fig. 1 und 2: perspektivische Darstellungen von zwei Gehäusen mit einem perforierten Durchlaß gemäß dem Stand der Technik und mit einem perforierten Durchlaß gemäß der Erfindung;
- Fig. 3: eine schematische Draufsicht auf einen perforierten Durchlaß gemäß dem Stand der Technik;
- Fig. 4: eine schematische Schnittdarstellung durch den perforierten Durchlaß der Fig. 3; und
- Fig. 5: eine schematische Schnittdarstellung durch einen perforierten Durchlaß gemäß der Erfindung; und
- Fig. 6: ein Diagramm der Strömungsverhältnisse in einer ventilatorgekühlten Einrichtung zur Erläuterung der Vorteile der Erfindung.

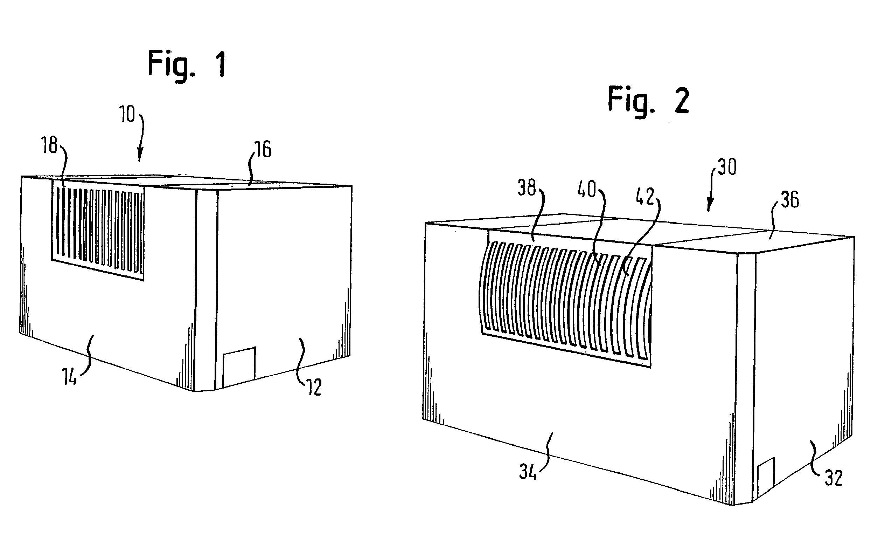

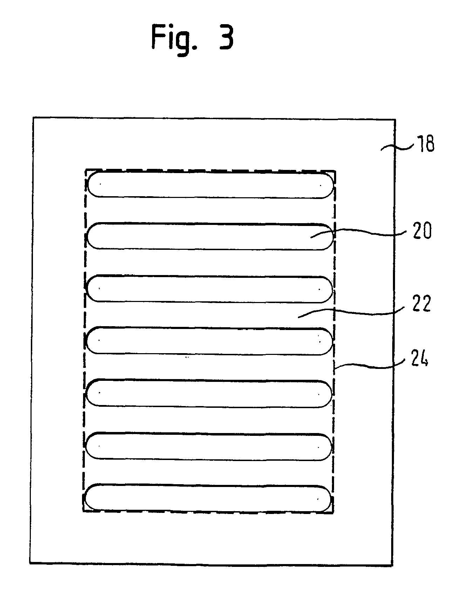

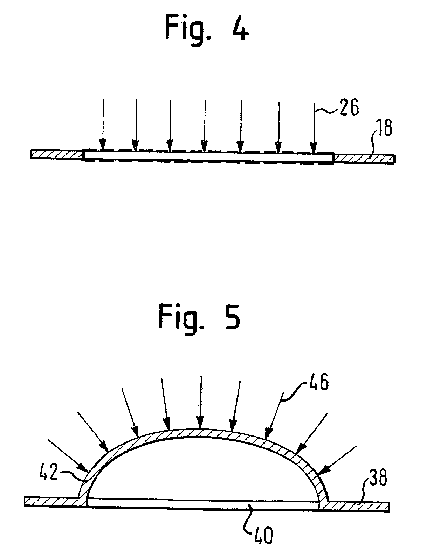

Fig. 1 zeigt schematisch ein Beispiel für ein Gehäuse 10 für beliebige elektronische oder elektrische Einrichtungen mit einer Seitenwand 12, einer Rückwand 14 (in der Zeichnung vorne) und einer Deckwand 16. Das Gehäuse 10 weist einen perforierten Durchlaß 18 auf, der als eine flache Metallplatte mit sich abwechselnden länglichen Schlitzen 20 und Stegen 22 ausgebildet ist. Eine schematische Draufsicht auf einen solchen perforierten Durchlaß gemäß dem Stand der Technik ist in Fig. 3, mit Schlitzen 20 und Stegen 22, dargestellt. Die Stege 22 werden auch als Metallbrücken bezeichnet. In Fig. 3 ist die Gesamtfläche des perforierten Bereichs durch eine Linie 24 eingegrenzt. In Fig. 4, die eine schematische Schittdarstellung durch die Durchlaßplatte 18 der Fig. 3 zeigt, ist die offene Luftdurchtrittsfläche, welche von den Stegen 22 eingegrenzt wird, schematisch durch Pfeile 26 gekennzeichnet.

Fig. 2 zeigt ein Gehäuse 30 für eine beliebige elektrische oder elektronische Einrichtung mit einer Seitenwand 32, einer Rückwand 34 und einer Deckwand 36 gemäß der Erfindung. In der Rückwand 34 sitzt eine perforierte Durchlaßplatte 38 zur Belüftung des Inneren des Gehäuses. Die Durchlaßplatte 38 weist Schlitze 40 auf, die durch nach außen gebogene Stege 42 eingegrenzt sind. Fig. 5 zeigt eine schematische Schnittdarstellung durch die Durchlaßplatte 38 mit einem gebogenen Steg 42, wobei Pfeile 46 die effektive Fläche der durch die gebogene Stege 42 eingegrenzten Durchlaßöffnungen schematisch andeuten.

Alternativ zu der gezeigten Ausführungsform können die Stege 42 auch in Richtung des Inneren des Gehäuses oder abwechselnd nach außen und nach innen gebogen sein. Sie können ferner in einer von der gezeigten Form abweichenden Form, kreisförmig, eckig, wellenförmig oder auf andere Weise gebogen sein. Wesentlich ist bei der erfindungsgemäßen Gestaltung der Durchlaßplatte 38, daß die Fläche der Durchlaßöffnungen 20 dadurch vergrößert wird, daß die die Öffnungen eingrenzenden Stege 42 aus der Ebene des Wandabschnitts, in dem die Durchlaßöffnung sitzt, herausversetzt sind. Insbesondere werden die Stege 42 durch Biegen verlängert, so daß sich die Fläche der von den Stegen eingegrenzten Durchlaßöffnungen 40 vergrößert. Anhand der zwei in den Fig. 1 und 2 gezeigten Gehäuse wurden folgende Vergleichsmessungen durchgeführt:
1. Für das in Fig. 1 gezeigte Gehäuse 10 wurde eine Standardperforation gewählt mit einer perforierten Fläche von 75 mm x 34,5 mm, welche gebildet wird durch insgesamt 16 Schlitze und 15 Stege mit einer Länge von 34,5 mm und einer Breite von 3 mm. Die Breite der Metallstege zwischen den Schlitzen betrug 1,8 mm. Hieraus ergibt sich ein Anteil der freien Fläche zur Gesamtfläche von 63 %.
2. Das erfindungsgemäße Gehäuse 30, das in Fig. 2 dargestellt ist, wurde mit einer Durchlaßplatte 38 versehen, die folgende Merkmale aufweist: Die Grundfläche des perforierten Durchlasses beträgt, wie bei der Ausführungsform der Fig. 1, 75 mm x 34,5 mm. Diese Grundfläche ist versehen mit insgesamt 16 Schlitzen und 15 Stegen mit einer gestreckten Länge von 37 mm (bei dem gewählten Beispiel) und mit einer Breite von 3 mm. Die Breite der Metallstege betrug ebenfalls 1,8 mm. Hieraus ergibt sich ein Anteil der freien Fläche zur Gesamtfläche der Durchlaßöffnung von ungefähr 68 %.
   Es wurde ein Lüfter des Typs NMB 3110 KL-04W-B60 (12V DC) verwendet, der einen maximalen statischen Druck von 45 Pa bzw. einen maximalen Durchsatz von 1,25 m³/min. liefern kann.
   - Ad 1.: Mit der Standardperforation gemäß Fig. 1 wurde eine Luftgeschwindigkeit von 1,34 m/s gemessen, die einer Luftströmungsrate von 0,5388 m³/min entspricht. Bei Nennleistung wurde ferner eine Lüfterdrehzahl von 3,627 Umdrehung pro Minute gemessen.
   - Ad 2: Mit der erfindungsgemäßen Gestaltung des Durchlasses 38, der in Fig. 2 gezeigt ist, ergab sich dagegen eine Luftgeschwindigkeit von 1,44 m/s, was einer Strömungsrate von 0,57 m³/min entspricht. Die bei derselben Leistung gemessene Lüfterdrehzahl betrug 3,570 Umdrehung pro Minute.
3. Um den Einfluß der erfindungsgemäßen Durchlaßplatte auf die Luftströmung im Vergleich zu der Durchlaßplatte gemäß dem Stand der Technik besser bewerten zu können, wurde zusätzlich die Luftströmung ohne den Strömungswiderstand, der durch die perforierte Durchlaßplatte erzeugt wird, gemessen, indem die Rückseite des Gehäuses entfernt wurde. Die gemessene Luftgeschwindigkeit betrug 2,88 m/s, was einer Strömungsrate von 1,14 m³/min entspricht. Die bei gleicher Leistung gemessene Lüfterdrehzahl betrug 3,710 Umdrehungen pro Minute.

Diese Vergleichsmessung zeigt den Strömungswiderstand des verbleibenden Systems, einschließlich den Druckabfall durch das Gehäuse und das rückwärtige Durchlaßloch aufgrund von Reibung und dergleichen. Aus einer Gesamtbetrachtung der Messungen ergibt sich eine Erhöhung der Strömungsrate von ungefähr 6 %, wenn anstelle der flachen Standardperforation die erfindungsgemäße Gestaltung des perforierten Durchlasses gemäß den Spezifikationen unter 2. oben verwendet wird. Eine genauere Analyse der Strömungs- bzw. Druckverhältnisse an den perforierten Flächen mit Hilfe einer Strömungssimulation (CFD) zeigt, daß sich beim gleichen Druckverlust von 15 Pa ein um ca. 12% erhöhter Durchsatz beziehungsweise beim gleichen Durchsatz von 0,09 m³/s ein um 26% verringerter Druckverlust einstellt, wenn anstelle der Standardperforation die Perforation gemäß dem gezeigten Ausfizhrungsbeispiel der Erfindung benutzt wird. Durch eine noch stärkere Biegung und Längung der Stege 42 zwischen den Durchlaßöffnungen kann dieser Faktor weiter erhöht werden.

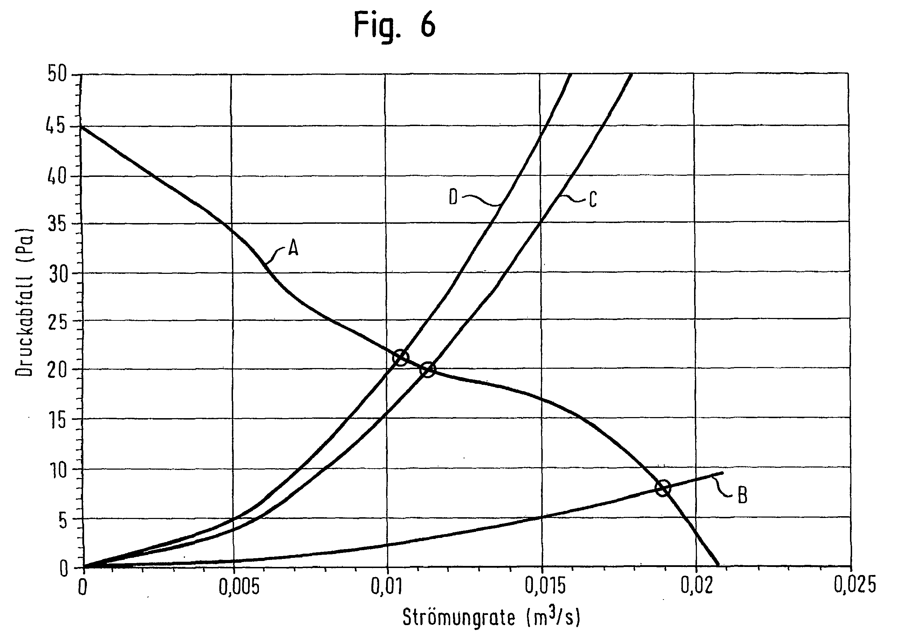

Fig. 6 zeigt ein Diagramm der Strömungskurven in einer mit einem Lüfter gekühlten Einrichtung, die gemäß den oben beschriebenen Ausführungsbeispielen modifiziert wurde. Die in Fig. 6 mit dem Buchstaben A bezeichnete Kurve stellt die Druck (P)- Strömungsraten (Q) - Kennlinie des Lüfters dar, der bei dem beschriebenen Ausführungsbeispiel verwendet wurde. Diese Kennlinie A bestimmt die Betriebspunkte des Systems. Wenn der Lüfter in einem Gehäuse betrieben wird, in dem die Rückseite entfernt wurde, gilt Kennlinie B; wenn der Lüfter in einem Gehäuse betrieben wird, das eine Durchlaßöffnung gemäß der Erfindung aufweist, gilt Kennlinie C; und wenn der Lüfter in einem Gehäuse betrieben wird, das einen Durchlaß mit einer Standardperforation gemäß dem Stand der Technik aufweist, gilt Kennlinie D. Die Darstellung der Fig. 6 zeigt, daß durch die erfindungsgemäße Gestaltung der Durchlaßöffnung eine höhere Strömungsrate bei einem geringeren Druckabfall unter Verwendung desselben Lüfters erreicht wird. Wie erläutert ergibt sich bei gleichem Druckverlust ein um etwa 12% erhöhter Durchsatz bzw. bei gleichem Durchsatz ein um etwa 26% verringerter Druckverlust bei dem untersuchten Ausführungsbeispiel. Es ist zu beachten, daß durch eine weitergehende Längung der Stege der Durchlaßplatte nochmals eine deutliche Erhöhung dieser Werte erreicht werden kann und es sich bei den dargestellten Ausführungsbeispielen um erste Versuchsanordnungen der Anmelderin handelt.

### Bezugszeichenliste

- 10: Gehäuse
- 12: Seitenwand
- 14: Rückwand
- 16: Deckwand
- 18: Durchlaßplatte
- 20: Schlitze
- 22: Stege
- 24: Linie zur Kennzeichnung der Durchlaßöffnung
- 26: Pfeile zur Kennzeichnung der effektiven Durchlaßfläche
- 30: Gehäuse
- 32: Seitenwand
- 34: Rückwand
- 36: Deckwand
- 38: Durchlaßplatte
- 40: Schlitze
- 42: Stege
- 46: Pfeile zur Kennzeichnung der effektiven Durchlaßfläche

## Patentansprüche

1. Komponente eines Gehäuses (30) für eine zu belüftende Einrichtung, mit einem flächigen Wandabschnitt und einem perforierten Durchlaß (38) in dem Wandabschnitt (34), der mehrere Öffnungen (40) und zwischen den Öffnungen liegende Stege (42) aufweist, **dadurch gekennzeichnet dass** *sämtliche* Stege (42) derart gebogen sind, daß sie von der Fläche des Wandabschnitts (34) vorstehen, so daß die freie Fläche der Öffnungen (40), welche durch die gebogenen Stege (42) eingegrenzt ist, im Verhältnis zu einer freien Fläche von Öffnungen, die durch entsprechende flache Stegen eingegrenzt ist, vergrößert ist.

2. Komponente nach Anspruch 1, **dadurch gekennzeichnet, daß** die Stege (42) in Verhältnis zu Stegen (22), die dem Flächenverlauf des Wandabschnitts folgen würden, verlängert sind.

3. Komponente nach Anspruch 2, **dadurch gekennzeichnet, daß** die Stege (42) um ungefähr 5-15% verlängert sind.

4. Komponente nach einem der Ansprüche 1 bis 3, **dadurch gekennzeichnet, daß** die Stege (42) in Form eines Ellipsensegmentes oder einer Welle gebogen sind.

5. Komponente nach einem der vorangehenden Ansprüche, **dadurch gekennzeichnet, daß** der Anteil der freien Fläche zur Gesamtfläche des perforierten Durchlasses (38) grö-βer als 60%, insbesondere größer als 68% ist.

6. Komponente nach einem der vorangehenden Ansprüche, **dadurch gekennzeichnet, daß** der Wandabschnitt (34) eine zweidimensionale oder dreidimensionale Fläche bildet

7. Komponente nach einem der vorangehenden Ansprüche, **dadurch gekennzeichnet, daß** der Wandabschnitt (34) aus Metall ist.

8. Gehäuse für eine elektrische oder elektronische Einrichtung mit einer Komponente nach einem der vorangehenden Ansprüche.

9. Gehäuse für eine Stromversorgung, die mit einem Lüfter gekühlt ist, mit einer Komponente nach einem der vorangehenden Ansprüche 1 bis 7.

## Claims

1. A component of a casing (30) for a piece of equipment to be ventilated which component has a flat wall portion (34) and a perforated opening (38) in the wall portion (34) which opening comprises multiple apertures (40) and lands (42) located between the apertures, **characterized in that** all lands (42) are bent to protrude from the surface of the wall portion (34) so that the open area of the openings (40), which is defined by the bent lands (42), is enlarged in relation to the open area of openings defined by corresponding flat lands.

2. The component according to claim 1, **characterized in that** the lands (42) are extended in relation to lands (22) which would follow the surface extension of the wall portion.

3. The component according to claim 2, **characterized in that** the lands (42) are extended by about 5 to 15 %.

4. The component according to any one of claims 1 to 3, **characterized in that** the lands (42) are bent in the form of an elliptical segment or a wave.

5. The component according to any one of the preceding claims, **characterized in that** the proportion of the open area in the total area of the perforated opening (38) is more than 60 %, specifically more than 68 %.

6. The component according to any one of the preceding claims, **characterized in that** the wall portion (34) forms a two-dimensional or three-dimensional surface.

7. The component according to any one of the preceding claims, **characterized in that** the wall portion (34) is made of metal.

8. A casing for a piece of electrical or electronic equipment having a component according to any one of the preceding claims.

9. A casing for a power supply unit cooled by a fan which casing has a component according to any one of the preceding claims 1 to 7.

## Revendications

1. Composant d'un boîtier (30) pour un dispositif à ventiler avec une section de paroi plane et un passage perforé (38) qui se trouve dans la section de paroi (34) et qui comprend plusieurs ouvertures (40) et des barrettes (42) placées entre les ouvertures, **caractérisé en ce que** toutes les barrettes (42) sont coudées de telle façon qu'elles dépassent de la surface de la section de paroi (34), de sorte que la surface libre des ouvertures (40) qui est délimitée par les barrettes coudées (42) est agrandie par rapport à une surface libre d'ouvertures qui est délimitée par des nervures plates correspondantes.

2. Composant selon la revendication 1, **caractérisé en ce que** les barrettes (42) sont rallongées par rapport à des barrettes (22) qui suivraient la forme de la surface de la section de paroi.

3. Composant selon la revendication 2, **caractérisé en ce que** les barrettes (42) sont rallongées d'environ 5 - 15%.

4. Composant selon l'une quelconque des revendications 1 à 3, **caractérisé en ce que** les barrettes (42) sont coudées avec la forme d'un segment d'ellipse ou d'une onduiation.

5. Composant selon l'une quelconque des revendications précédentes, **caractérisé en ce que** la quote-part de la surface libre par rapport à la surface totale du passage perforé (38) est supérieure à 60%, en particulier supérieure à 68%.

6. Composant selon l'une quelconque des revendications précédentes, **caractérisé en ce que** la section de paroi (34) forme une surface bidimensionnelle ou tridimensionnelle.

7. Composant selon l'une quelconque des revendications précédentes, **caractérisé en ce que** la section de paroi (34) est réalisée en métal.

8. Boîtier pour un dispositif électrique ou électronique avec un composant selon l'une quelconque des revendications précédentes.

9. Boîtier pour une alimentation électrique refroidie par un ventilateur qui comprend un composant selon l'une quelconque des revendications précédentes 1 à 7.
